# EUROPEAN PATENT APPLICATION

(11) **EP 2 003 594 A1**
(43) Date of publication of application: **17.12.2008**
(21) Application number: 08156055.9
(22) Date of filing: 12.05.2008
(51) Int. Cl.: G06K 7/00

(54) **Card detection apparatus and method**

(30) Priority: 04.06.2007 KR 20070054535
(71) Applicant: Tyco Electronics AMP Korea Limited, Kyungsangbuk-Do, 712-838 (KR)
(72) Inventor: Kim, Jung-Hoon, Kyungsangbuk-Do, 712-838 (KR)
(74) Representative: Townsend, Stephen

(57) **Abstract**

An apparatus and method for detecting cards is provided, which can accurately detect insertion and ejection of a card simply by using terminals formed on the card without a separate device for detecting cards. The apparatus includes a card, a card detection unit, a controller, and a data processing unit. The card includes a plurality of card detection terminals. The card detection unit generates a detection signal for determining whether or not the card has been inserted using the difference of times when the card detection terminals are connected to the card detection unit. The controller analyzes the detection signal generated by the card detection unit to determine whether or not the card has been inserted and outputting insertion information of the card according to the determination. The data processing unit writes or reads information to or from the card according to the card insertion information output from the controller.

## Description

### BACKGROUND OF THE INVENTION

### Field of the Invention

The present invention relates to card detection, and more particularly to an apparatus and method for detecting cards, wherein it is possible to accurately detect insertion and ejection of a card simply by using terminals formed on the card without a separate device for detecting cards.

### Description of the Related Art

Generally, external cards (for example, memory cards) are used to expand storage capacity in various devices such as mobile phones, PDAs, or digital cameras. Cards in a variety of formats with different sizes or standards have been introduced, including Secure Digital (SD), Multimedia Card (MMC), Compact Flash (CF), and memory stick.

Recent mobile phones have various functions. Some mobile phones have a function that is used as a means for payment with credit card information embedded therein, and some are even used as an audio/video player.

Conventional mobile phones typically use internal memory to implement a Video on Demand (VOD) or MP3 player function. As the variety of functions of mobile phones increases, mobile phones have encountered the problem of limited internal memory capacity.

External memory cards have been introduced to overcome problems associated with internal memories. Various technologies have been developed to install such a card in a mobile phone. Various other conventional technologies have also been developed to detect insertion and ejection of a card.

In one conventional method of detecting cards, a contact switch, which is separately provided on a card connection module at a position on the module, is turned on and off as a card is inserted to generate different signals. Whether or not the card has been inserted or ejected is determined using the generated signals.

In another conventional method, whether or not a card has been inserted or ejected is determined using a mechanism for detecting cards that is separately provided on a card connection module at a position on the module.

However, these conventional methods increase the complexity of card connection modules and make it difficult to decrease the size of card connection modules since the methods use a separate device for detecting cards as described above.

### SUMMARY OF THE INVENTION

Therefore, the present invention has been made in view of the above problems, and it is an object of the present invention to provide an apparatus and method for detecting cards, wherein it is possible to accurately detect insertion and ejection of a card simply by using terminals formed on the card without a separate device for detecting cards.

It is another object of the present invention to provide an apparatus and method for detecting cards, wherein, using information indicating whether or not the card has been inserted or ejected, it is possible to prevent an erroneous operation of a card reader which writes or reads information to or from the card.

In accordance with one aspect of the present invention, the above and other objects can be accomplished by the provision of an apparatus for detecting insertion and ejection of cards, the apparatus including a card including at least one card detection terminal; a card detection unit for generating a detection signal to determine whether or not the card has been inserted using a connection time difference of the at least one card detection terminal; a controller for analyzing the detection signal generated by the card detection unit to determine whether or not the card has been inserted and outputting insertion information of the card according to the determination; and a data processing unit for writing or reading information to or from the card according to the insertion information of the card output from the controller.

The at least one card detection terminal includes a plurality of card detection terminals that are formed at different positions so that the card detection terminals are connected to the card detection terminal unit at different times. The card detection unit includes a plurality of detection switches that are turned on or off according to whether or not the card detection unit has been connected to the card detection terminal; and a plurality of buffers for shaping input signals that vary according to switching operations of the detection switches and outputting the shaped input signals as detection signals for determining whether or not the card has been inserted.

In accordance with another aspect of the present invention, the above and other objects can be accomplished by the provision of a method for detecting insertion and ejection of cards, the method including receiving, in a predetermined order, a plurality of detection signals generated according to whether or not a card detection terminal formed on a card has been connected in a standby mode for awaiting insertion of the card; analyzing the plurality of received detection signals in the order in which the plurality of detection signals have been received, determining whether or not the card has been inserted according to the analysis, and transmitting card insertion information to a data processing unit that writes or reads data to or from the card if it is determined that the card has been inserted according to the analysis; constantly checking whether or not the plurality of detection signals have been changed while the card has been inserted; and determining that the card has been ejected if it is determined that all the plurality of detection signals have been changed and transmitting card ejection information to the data processing unit.

In accordance with another aspect of the present invention, the above and other objects can be accomplished by the provision of a method for detecting insertion and ejection of cards, the method including receiving, in a predetermined order, a plurality of detection signals generated according to whether or not a card detection terminal formed on a card has been connected in a standby mode for awaiting insertion of the card; analyzing the plurality of received detection signals in the order in which the plurality of detection signals have been received, determining whether or not the card has been inserted according to the analysis, and transmitting, if it is determined that the card is being inserted according to the analysis, information indicating that the card is being inserted to a data processing unit that writes or reads data to or from the card to prevent the data processing unit from performing an erroneous operation; constantly checking, if it is determined that the card has been fully inserted according to the analysis, whether or not the plurality of detection signals have been changed while the card has been inserted; and determining that the card is being ejected if it is determined that the plurality of detection signals have been partially changed and transmitting information indicating that the card is being ejected to the data processing unit to prevent the data processing unit from performing an erroneous operation.

### BRIEF DESCRIPTION OF THE DRAWINGS

The above and other objects, features and other advantages of the present invention will be more clearly understood from the following detailed description taken in conjunction with the accompanying drawings, in which:
FIG. 1 is a side cross-sectional view of a first embodiment of an apparatus for detecting cards according to the invention wherein a card has been coupled to the apparatus;
FIG. 2 is a block diagram illustrating the configuration of the first embodiment of the apparatus for detecting cards according to the invention;
FIG. 3 is a circuit diagram illustrating a detailed configuration of a card detection unit in FIG. 2;
FIG. 4 is a side cross-sectional view of a second embodiment of an apparatus for detecting cards according to the invention wherein a card has been coupled to the apparatus;
FIG. 5 is a block diagram illustrating the configuration of the second embodiment of the apparatus for detecting cards according to the invention;
FIG. 6 is a circuit diagram illustrating a detailed configuration of a card detection unit in FIG. 5;
FIG. 7 is a flow chart illustrating a first embodiment of a method for detecting cards according to the invention; and
FIG. 8 is a flow chart illustrating a second embodiment of a method for detecting cards according to the invention.

### DETAILED DESCRIPTION OF THE PREFERRED EMBODIMENTS

The preferred embodiments of the present invention will now be described with reference to the accompanying drawings. In the following description of the invention, a detailed description of known functions and configurations incorporated herein will be omitted when it may obscure the subject matter of the invention.

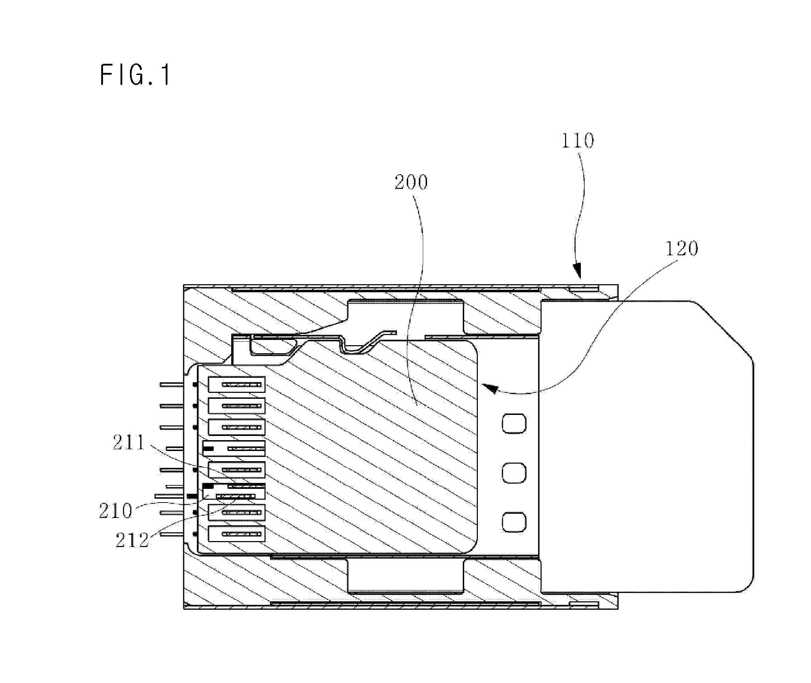

FIG. 1 is a side cross-sectional view of a first embodiment of an apparatus for detecting cards according to the invention wherein a card has been coupled to the apparatus.

As shown in FIG. 1, a card 200 is inserted into and coupled to a card inserting portion 120 in a card connection module 110. The card 200 includes a card detection terminal unit 210 including a plurality of card detection terminals, for example two card detection terminals 211 and 212.

The card detection terminals 211 and 212 are formed at different positions so that they are connected to a connection unit formed in the card connection module 110 at different times when the card 200 is inserted into the card inserting portion 120. That is, the two card detection terminals 211 and 212 are constructed such that they are not simultaneously connected to the connection unit when the card 200 is inserted into the card inserting portion 120 and, instead, the card detection terminal 211 is first connected to the connection unit when the card 200 has been slightly inserted into the card inserting portion 120 and the card detection terminal 212 is then connected to the connection unit when the card 200 has been fully inserted into the card inserting portion 120.

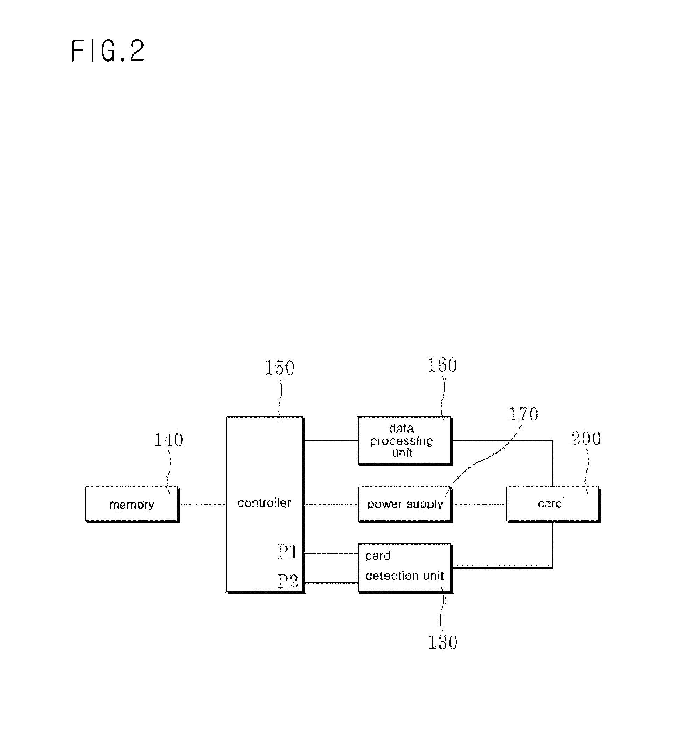

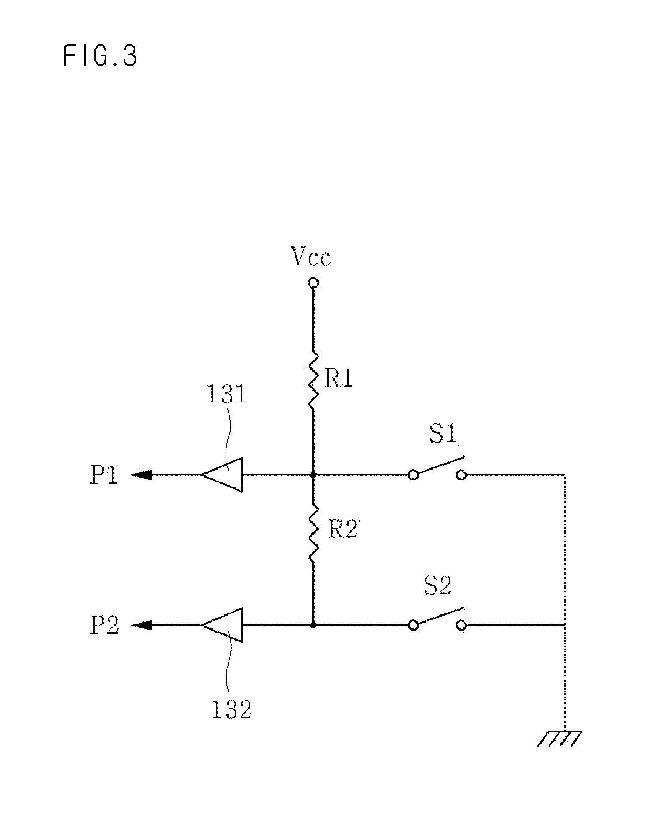

FIG. 2 is a block diagram illustrating the configuration of the first embodiment of the apparatus for detecting cards according to the invention and FIG. 3 is a circuit diagram illustrating a detailed configuration of a card detection unit in FIG. 2.

As shown in FIGS. 2 and 3, the first embodiment of the apparatus for detecting cards according to the invention includes a card 200, a card detection unit 130, a controller 150, and a data processing unit 160. The card 200 includes a card detection terminal unit 210 having card detection terminals 211 and 212. The card detection unit 130 generates a detection signal for determining whether or not the card 200 has been inserted using the difference between times when the card detection terminals 211 and 212 are connected to the card detection unit 130. The controller 150 analyzes the detection signal generated by the card detection unit 130 to determine whether or not the card 200 has been inserted and outputs insertion information of the card 200 according to the determination. The data processing unit 160 writes information to the card 200 or reads information written on the card 200 according to the insertion information of the card 200 output from the controller 150.

The first embodiment of the apparatus for detecting cards according to the invention further includes a memory 140 for storing a control program and control data and a power supply 170 for supplying or interrupting power to the card 200 under control of the controller 150.

The card detection unit 130 includes a plurality of detection switches S1 and S2 and a plurality of buffers 131 and 132. The detection switches S1 and S2 are turned on or off according to whether or not the card detection unit 130 has been connected to the card detection terminals 211 and 212. The buffers 131 and 132 shape input signals which vary according to switching operations of the detection switches S1 and S2 and output the shaped input signals as detection signals for determining whether or not the card 200 has been inserted.

When the user inserts an external card 200 to a card inserting portion 120 of a user device (for example, a mobile phone), the first embodiment of the apparatus for detecting cards according to the invention detects the insertion at the card detection unit 130.

The card detection terminals 211 and 212 of the card 200 are formed at different positions. Specifically, the card detection terminal 211 is positioned closer to a card insertion opening of the user device than the card detection terminal 212.

Thus, when the card 200 is inserted, first, the card detection terminal 211 is connected to a first detection terminal (not shown) in the card connection module 110. Therefore, when the card 200 begins to be inserted, the detection switch S1 in the card detection unit 130, which interlocks with the first detection terminal, is turned on, thereby grounding a resister R1. This drops an input signal to the buffer 131 to a low level so that a low signal is input, as a detection signal for determining whether or not the card 200 has been inserted, to a port P1 of the controller 150.

Then, when the card 200 is further inserted, the card detection terminal 212 is connected to a second detection terminal (not shown) in the card connection module 110. Therefore, when the card 200 is further inserted, the detection switch S2 in the card detection unit 130, which interlocks with the second detection terminal, is turned on, thereby grounding a resister R2. This drops an input signal to the buffer 132 to a low level so that a low signal is input, as a detection signal for determining whether or not the card 200 has been inserted, to a port P2 of the controller 150.

When the card 200 has not been inserted, both the detection switches S1 and S2 are off and therefore a voltage Vcc applied to resistors R1 and R2 is directly applied to the buffers 131 and 132, thereby maintaining output signals of the buffers 131 and 132 at a high level.

The detection switches S1 and S2 are switch circuits for physically detecting the card detection terminals 211 and 212. Preferably, the detection switches S1 and S2 are embodied using ground pads.

The controller 150 analyzes the detection signals input to the ports P1 and P2. The controller 150 determines that the card 200 is being inserted if the signal input to the port P1 is at a low level. Then, if the signal input to the port P2 is at a low level, the controller 150 determines that the card 200 has been fully inserted and drives the power supply 170 to supply power to the card 200. The controller 150 also sends a signal indicating that the card 200 has been inserted to the data processing unit 160, thereby causing the data processing unit 160 to read data written on the inserted card 200 or to write data to the card 200 as needed. The data processing unit 160 may be a card reader for physically writing information on the card 200 or reading information written on the card 200.

When the user ejects the card 200 coupled to the card inserting portion 120, first, the card detection terminal 212 is disconnected from the second detection terminal (not shown) in the card connection module 110 and the detection switch S2 in the card detection unit 130, which interlocks with the second detection terminal, is turned off so that the voltage applied to the resistor R2 is directly applied to the buffer 132. This raises an input signal to the buffer 132 to a high level so that a high signal is input, as a detection signal for determining whether or not the card 200 has been inserted, to the port P2 of the controller 150.

Then, when the card 200 has been fully ejected, the card detection terminal 211 is disconnected from the first detection terminal (not shown) in the card connection module 110 and the detection switch S1 in the card detection unit 130, which interlocks with the first detection terminal, is turned off so that the voltage applied to the resistor R1 is directly applied to the buffer 131. This raises an input signal to the buffer 131 to a high level so that a high signal is input, as a detection signal for determining whether or not the card 200 has been inserted, to the port P1 of the controller 150.

The controller 150 analyzes the detection signals input to the ports P1 and P2. The controller 150 determines that the card 200 is being ejected if the signal input to the port P2 is at a high level. Then, if the signal input to the port P1 is at a high level, the controller 150 determines that the card 200 has been fully ejected and controls the power supply 170 to interrupt power to the card 200. The controller 150 also sends a signal indicating that the card 200 has been ejected to the data processing unit 160. This causes the data processing unit 160 to stop reading data written on the inserted card 200 or writing data to the card 200.

As described above, using the plurality of card detection terminals eliminates the need to provide a separate device for detecting cards as in the related art. Since the card detection terminals are sequentially detected at different times, it is possible to accurately detect insertion or ejection of a card.

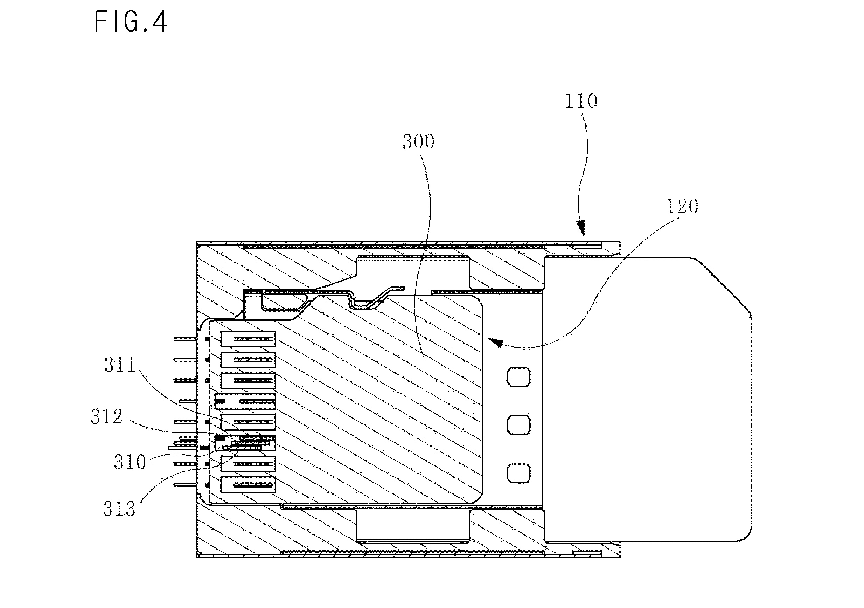

FIG. 4 is a side cross-sectional view of a second embodiment of an apparatus for detecting cards according to the invention wherein a card has been coupled to the apparatus. This embodiment is different from the first embodiment shown in FIG. 1 only in that a card detection terminal unit 310 formed in a card 300 includes three card detection terminals 311, 312, and 313.

The card detection terminals 311, 312, and 313 are formed at different positions so that they are connected to a connection unit formed in the card connection module 110 at different times when the card 300 is inserted into the card inserting portion 120. That is, the three card detection terminals 311, 312, and 313 are constructed such that they are not simultaneously connected to the connection unit when the card 300 is inserted into the card inserting portion 120 and, instead, the card detection terminal 311 is first connected to the connection unit when the card 300 has been slightly inserted into the card inserting portion 120, the card detection terminal 312 is then connected to the connection unit when the card 300 has been further inserted into the card inserting portion 120, and the card detection terminal 313 is finally connected to the connection unit when the card 300 has been fully inserted into the card inserting portion 120.

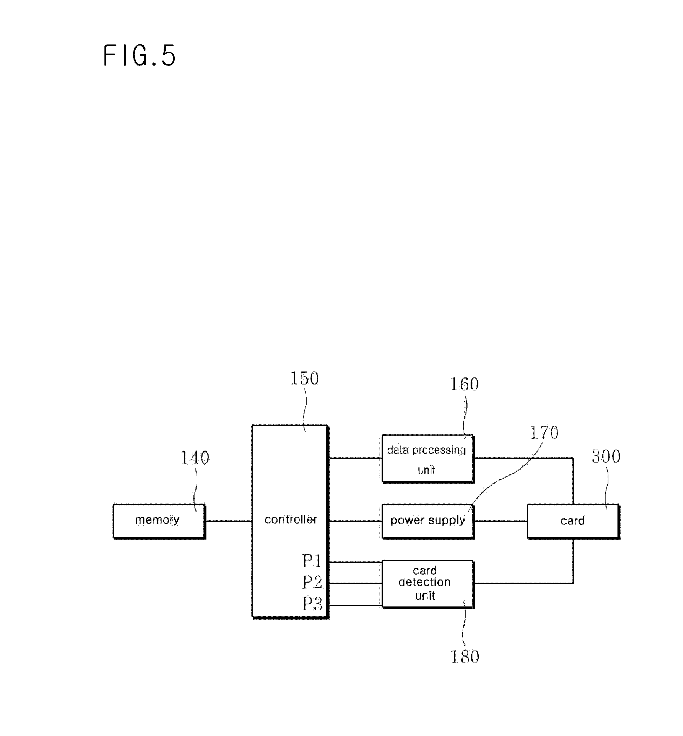

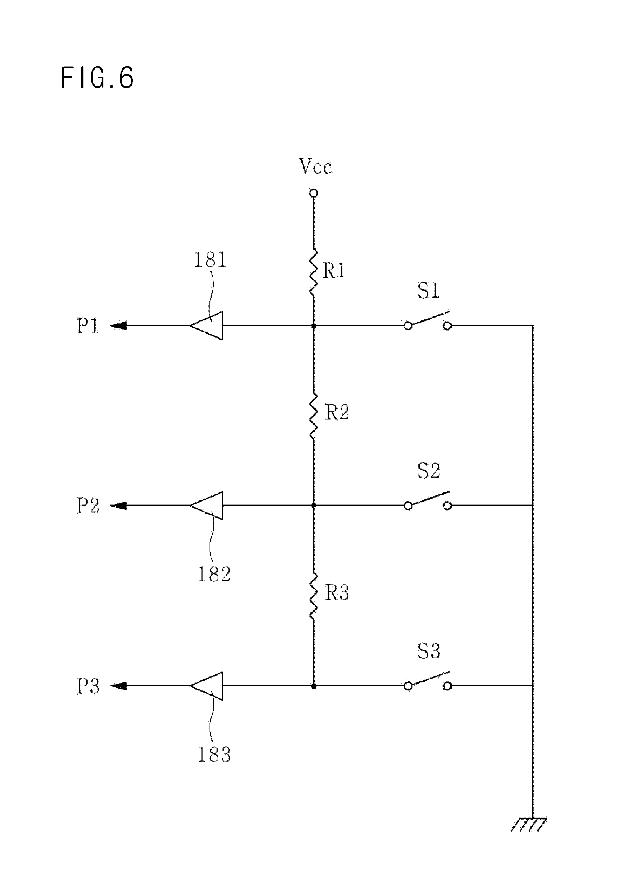

FIG. 5 is a block diagram illustrating the configuration of the second embodiment of the apparatus for detecting cards according to the invention and FIG. 6 is a circuit diagram illustrating a detailed configuration of a card detection unit in FIG. 5.

This embodiment is different from the first embodiment shown in FIGS. 2 and 3 only in that the controller 150 includes three ports P1, P2, and P3 through which it receives detection signals for determining whether or not the card has been inserted and circuitry for the card detection unit 180 includes three detection switches S1, S2, and S3 and three buffers 181, 182, and 182. The other components of the second embodiment shown in FIGS. 5 and 6 are similar to those of the first embodiment shown in FIGS. 2 and 3.

The detection switches S1, S2, and S3 are switch circuits for physically detecting the card detection terminals 311, 312, and 313. Preferably, the detection switches S1, S2, and S3 are embodied using ground pads.

The following is a brief description of the operation of the second embodiment. When the card 300 is inserted into the card inserting portion 120, the card detection terminal 311, the card detection terminal 312, and the card detection terminal 313 are sequentially connected to first, second, and third connection terminals provided in the card connection module 110 at different times.

When the card 300 is ejected from the card inserting portion 120, the card detection terminal 313, the card detection terminal 312, and the card detection terminal 311 are sequentially disconnected from the third, second, and first connection terminals provided in the card connection module 110 at different times.

When the card 300 is inserted, the detection switch S1, the detection switch S2, and the detection switch S3 in the card detection portion 180 are sequentially turned on at different times. When the card 300 is ejected, the detection switch S3, the detection switch S2, and the detection switch S1 are sequentially turned off at different times.

When the card 300 is inserted, a buffer 181, a buffer 182, and a buffer 183 sequentially apply low signals as detection signals to the controller 150 at different times according to such operations of the detection switches S1, S2, and S3. When the card 300 is ejected, the buffer 183, the buffer 182, and the buffer 181 sequentially apply high signals as detection signals to the controller 150 at different times.

The controller 150 analyzes detection signals input to the ports P1, P2, and P3 to control the power supply 170 and the data processing unit 160. In the second embodiment of the invention, if the input signals to the ports P1 and P2 sequentially drop to a low level when the card 300 is inserted, the controller 150 informs the data processing unit 160 that the card 300 is being inserted, unlike the first embodiment. This allows the data processing unit 160 to operate in standby mode and also prevents the data processing unit 160 from performing an erroneous operation such as attempting to access the card or reading data on the card even though the card has not been fully inserted.

If the input signal to the port P3 then drops to a low level, the controller 150 supplies power to the memory card 300 through the power supply 170 and provides a signal indicating that the card 300 has been fully inserted to the data processing unit 160 and allows the data processing unit 160 to normally access the card 300.

On the other hand, if the input signals to the ports P3 and P2 sequentially rise to a high level when the card 300 is ejected, the controller 150 informs the data processing unit 160 that the card 300 is being ejected. This allows the data processing unit 160 to operate in standby mode and also prevents the data processing unit 160 from performing an erroneous operation such as attempting to read data on the card even though the card has been ejected.

If the input signal to the port P1 then rises to a high level, the controller 150 interrupts power supplied to the memory card 300 through the power supply 170 and provides a signal indicating that the card 300 has been fully ejected to the data processing unit 160 and allows the data processing unit 160 to normally terminate the access to the card 300.

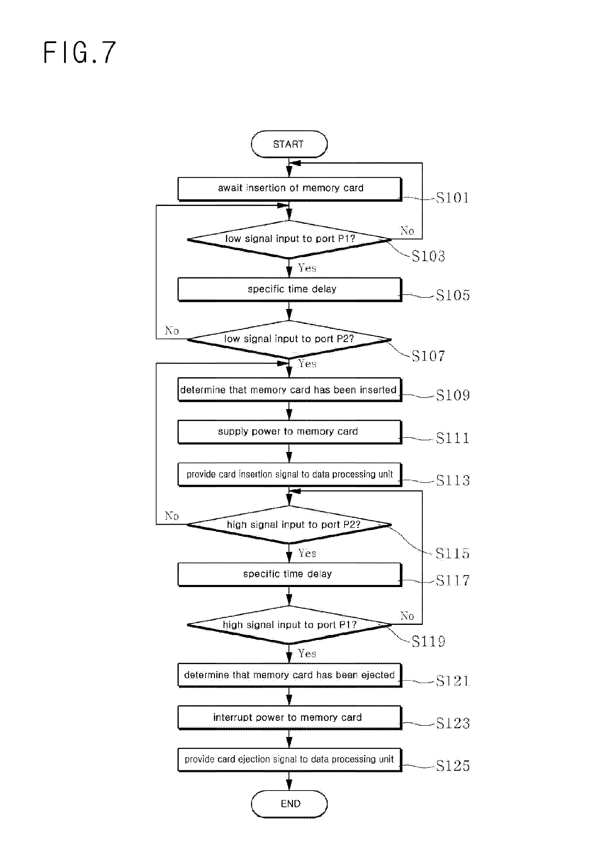

FIG. 7 is a flow chart illustrating a first embodiment of a method for detecting cards according to the invention.

As shown in FIG. 7, the controller 150 awaits insertion of the card 200 at step S101, and then checks at step S103 whether or not a low signal has been input to the port P1. If the input signal to the port P1 is at a low level, the controller 150 proceeds to step S105 to undergo a specific time delay. Then, at step S107, the controller 150 checks whether or not a low signal has been input to the port P2. While the card 200 is not inserted, the input signals to the ports P1 and P2 are kept at a high level. The controller 150 undergoes a specific time delay at the above step S105 since the card detection terminals 211 and 212 are formed on the card 200 such that the card detection terminals are connected to corresponding connection terminals in the card connection module 110 at different times.

If the input signal to the port P2 is not at a low level, the controller 150 returns to the above step S103. This indicates that the card 200 has not been fully inserted into the card insertion opening of the mobile phone although the user has begun to insert the card 200 into the card insertion opening.

The input signal to the port P2 is also at a low level when the card 200 has been fully inserted into the card insertion opening. Therefore, if it is determined at step S107 that the input signal to the port P2 is at a low level, the controller 150 proceeds to step S109 to determine that the card 200 has been inserted and then supplies power to the card 200 at step S111. Then, at step S113, the controller 150 provides a card insertion signal to the data processing unit 160 to cause the data processing unit 160 to perform subsequent operations.

At step S115, the controller 150 checks whether or not the input signal to the port P2 is at a high level while the card 200 has been inserted into the card insertion portion as described above. If the input signal to the port P2 is at a high level, the controller 150 proceeds to step S117 to undergo a specific time delay. Then, at step S119, the controller 150 checks whether or not the input signal to the port P1 is also at a high level. The input signal to the port P1 is not at a high level when the card 200 has been partially ejected. Therefore, if it is determined at step S119 that the input signal to the port P1 is not at a high level, the controller 150 returns to the above step S115. On the other hand, if the input signal to the port P1 is at a high level, the controller 150 proceeds to step S121 to determine that the card 200 has been ejected and proceeds to step S123 to interrupt power to the card. Then, the controller 150 proceeds to step S125 to provide a card insertion signal to the data processing unit 160 to prevent the data processing unit 160 from performing an erroneous operation such as attempting to access the card or attempting to read or write data from or to the card even though the card has been ejected.

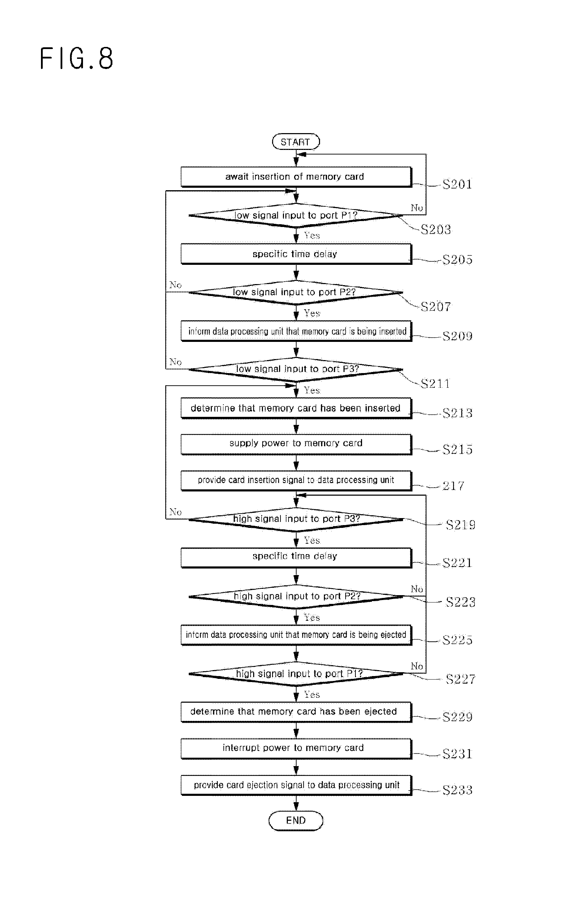

FIG. 8 is a flow chart illustrating a second embodiment of a method for detecting cards according to the invention.

As shown in FIG. 7, the controller 150 awaits insertion of the card 300 at step S201, and then checks at step S203 whether or not a low signal has been input to the port P1. If the input signal to the port P1 is at a low level, the controller 150 proceeds to step S205 to undergo a specific time delay. Then, at step S207, the controller 150 checks whether or not a low signal has been input to the port P2. While the card 300 is not inserted, the input signals to the ports P1 and P2 are kept at a high level. The controller 150 undergoes a specific time delay at the above step S205 since the card detection terminals 311, 312, and 313 are formed on the card 300 such that the card detection terminals are connected to corresponding connection terminals in the card connection module 110 at different times.

If the input signal to the port P2 is not at a low level, the controller 150 returns to the above step S203. This indicates that the card 300 has been slightly inserted into the card insertion opening of the mobile phone while the user inserts the card 300 into the card insertion opening.

On the other hand, if the input signal to the port P2 is also at a low level, the controller 150 proceeds to step S209 to inform the data processing unit 160 that the card 300 is being inserted. This readies the data processing unit 160 for insertion of the card 300 since the card 300 is being inserted.

Then, at step S211, the controller 150 checks whether or not the input signal to the port P3 is at a low level. If the input signal to the port P3 is not at a low level, the controller 150 returns to the above step S203. The input signal to the port P3 is also at a low level when the card 300 has been fully inserted. Therefore, if the input signal to the port P3 is at a low level, the controller 150 proceeds to step S213 to determine that the card 300 has been inserted and then supplies power to the card 300 at step S215. Then, at step S217, the controller 150 provides a card insertion signal to the data processing unit 160 to cause the data processing unit 160 to perform subsequent operations.

At step S219, the controller 150 checks whether or not the input signal to the port P3 is at a high level while the card 300 has been inserted into the card insertion portion as described above. If the input signal to the port P3 is at a high level, the controller 150 proceeds to step S221 to undergo a specific time delay. Then, at step S223, the controller 150 checks whether or not the input signal to the port P2 is also at a high level. The input signal to the port P2 is not at a high level when the card 300 has been partially ejected. Therefore, if it is determined at step S223 that the input signal to the port P2 is not at a high level, the controller 150 returns to the above step S219. On the other hand, the input signal to the port P2 is at a high level when the card 300 has been significantly ejected. Therefore, if the input signal to the port P2 is at a high level, the controller 150 proceeds to step S225 to inform the data processing unit 160 that the card 300 is being ejected. Here, the controller previously provides a standby signal to the data processing unit 160 since the data processing unit 160 may perform an erroneous operation if the card 300 is instantly ejected while the data processing unit 160 writes or reads data to or from the card 300. Upon receiving this standby signal, the data processing unit 160 prepares to immediately terminate an ongoing operation.

Then, at step S227, the controller 150 checks whether or not the input signal to the port P1 is also at a high level. If the input signal to the port P1 is not at a high level, the controller 150 returns to the above step S219 to perform the subsequent steps. The input signal to the port P1 is at a high level when the card 300 has been fully ejected from the card insertion portion. Therefore, if the input signal to the port P1 is at a high level, the controller 150 proceeds to step S229 to determine that the card 300 has been ejected and then proceeds to step S231 to interrupt power to the card 300. Then, the controller 150 proceeds to step S223 to provide a card insertion signal to the data processing unit 160 to prevent the data processing unit 160 from performing an erroneous operation such as attempting to access the card 300 or attempting to read or write data from or to the card 300 even though the card 300 has been ejected.

As is apparent from the above description, the invention provides a method and apparatus for detecting cards with a variety of advantages. For example, it is possible to correctly detect whether or not a card has been inserted or ejected using only the terminals provided on the card without a separate device for detecting cards.

Using information indicating whether or not the card has been inserted or ejected, it is also possible to prevent an erroneous operation of a card reader which writes or reads information to or from the card.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. An apparatus for detecting insertion and ejection of cards, the apparatus comprising:
a card including at least one card detection terminal;
a card detection unit for generating a detection signal to determine whether or not the card has been inserted using a connection time difference of the at least one card detection terminal;
a controller for analyzing the detection signal generated by the card detection unit to determine whether or not the card has been inserted and outputting insertion information of the card according to the determination; and
a data processing unit for writing or reading information to or from the card according to the insertion information of the card output from the controller.

2. The apparatus according to claim 1, wherein the at least one card detection terminal includes a plurality of card detection terminals that are formed at different positions so that the card detection terminals are connected to the card detection terminal unit at different times.

3. The apparatus according to claim 2, wherein the plurality of card detection terminals is two card detection terminals formed at different positions.

4. The apparatus according to claim 2, wherein the plurality of card detection terminals is three card detection terminals formed at different positions.

5. The apparatus according to claim 1, wherein the card detection unit includes:
a plurality of detection switches that are turned on or off according to whether or not the card detection unit has been connected to the card detection terminal; and
a plurality of buffers for shaping input signals that vary according to switching operations of the detection switches and outputting the shaped input signals as detection signals for determining whether or not the card has been inserted.

6. The apparatus according to claim 1, wherein the card detection unit includes a ground pad for detecting whether or not the card detection unit has been connected to the card detection terminal.

7. A method for detecting insertion and ejection of cards, the method comprising:
receiving, in a predetermined order, a plurality of detection signals generated according to whether or not a card detection terminal formed on a card has been connected in a standby mode for awaiting insertion of the card;
analyzing the plurality of received detection signals in the order in which the plurality of detection signals have been received, determining whether or not the card has been inserted according to the analysis, and transmitting card insertion information to a data processing unit that writes or reads data to or from the card if it is determined that the card has been inserted according to the analysis;
constantly checking whether or not the plurality of detection signals have been changed while the card has been inserted; and
determining that the card has been ejected if it is determined that all the plurality of detection signals have been changed and transmitting card ejection information to the data processing unit.

8. The method according to claim 7, wherein the step of determining whether or not the card has been inserted according to the analysis includes determining that the card has been inserted if it is determined according to the analysis that the plurality of received detection signals have all been sequentially changed such that respective phases of the plurality of received detection signals are all different from respective phases of a plurality of previously received detection signals.

9. A method for detecting insertion and ejection of cards, the method comprising:
receiving, in a predetermined order, a plurality of detection signals generated according to whether or not a card detection terminal formed on a card has been connected in a standby mode for awaiting insertion of the card;
analyzing the plurality of received detection signals in the order in which the plurality of detection signals have been received, determining whether or not the card has been inserted according to the analysis, and transmitting, if it is determined that the card is being inserted according to the analysis, information indicating that the card is being inserted to a data processing unit that writes or reads data to or from the card to prevent the data processing unit from performing an erroneous operation;
transmitting, if it is determined that the card has been fully inserted according to the analysis, information indicating that the card has been inserted to the data processing unit, and constantly checking whether or not the plurality of detection signals have been changed while the card has been inserted; and
determining that the card is being ejected if it is determined that the plurality of detection signals have been partially changed and transmitting information indicating that the card is being ejected to the data processing unit to prevent the data processing unit from performing an erroneous operation.

10. The method according to claim 9, wherein the step of determining whether or not the card has been inserted according to the analysis includes determining that the card has been inserted if it is determined according to the analysis that the plurality of received detection signals have all been sequentially changed such that respective phases of the plurality of received detection signals are all different from respective phases of a plurality of previously received detection signals, and determining that the card is being inserted if it is determined according to the analysis that one or more of the plurality of received detection signals have been sequentially changed such that respective phases of the one or more of the plurality of received detection signals are all different from respective phases of corresponding one or more of a plurality of previously received detection signals.

11. The method according to claim 9, further comprising:
determining that the card has been ejected if it is determined that the plurality of detection signals have all been changed and transmitting information indicating that the card has been ejected to the data processing unit.
